# EUROPEAN PATENT SPECIFICATION

(11) **EP 0 561 236 B1**
(45) Date of publication and mention of the grant of the patent: **24.01.2001**
(21) Application number: 93103573.7
(22) Date of filing: 05.03.1993
(51) Int. Cl.: H01L 21/306

(54) **An aqueous ammonia composition for the cleaning of semi-conductor substrates**
Wässrige, Ammoniak enthaltende, Zusammensetzung für die Reinigung von Halbleitersubstraten
Composition aqueuse à base d'ammoniaque pour le nettoyage de substrats semi-conducteurs

(30) Priority: 06.03.1992 JP 9751692
(43) Date of publication of application: 22.09.1993
(73) Proprietor: NISSAN CHEMICAL INDUSTRIES LTD., Tokyo (JP); KANTO KAGAKU KABUSHIKI KAISHA, Chuo-ku Tokyo 103 (JP)
(72) Inventor: Morikawa, Fumihiro, c/o Nissan Chem. Ind., Ltd., Fuchumachi, Nei-gun, Toyama-ken (JP); Yoshikawa, Akihisa, c/o Nissan Chem. Ind., Ltd., Fuchumachi, Nei-gun, Toyama-ken (JP); Ishikawa, Norio, c/o Kanto Kagaku K.K., Soka-shi, Saitama-ken (JP); Shihoya, Takao, c/o Kanto Kagaku K.K., Chuo-ku, Tokyo (JP)
(74) Representative: VOSSIUS & PARTNER

(56) References cited:
- EP-A- 0 416 126
- PATENT ABSTRACTS OF JAPAN vol. 13, no. 195 (E-754)10 May 1989
- IEEE TRANSACTIONS ON SEMICONDUCTOR MANUFACTURING vol. 2, no. 3, August 1989, NEW YORK US pages 69 - 75 MISHIMA ET AL 'Particle-free wafer cleaning and drying technology'
- JOURNAL OF THE ELECTROCHEMICAL SOCIETY vol. 137, no. 4, April 1990, MANCHESTER, NEW HAMPSHIRE US pages 1239 - 1243 VAN DEN MEERAKKER ET AL 'A mechanistic study of silicon etching in NH3/H2O2 cleaning solutions'
- IBM TECHNICAL DISCLOSURE BULLETIN. vol. 26, no. 12, May 1984, NEW YORK US pages 6456 - 6457 CAZCARRA ET AL 'Improvements to surface characteristics of silicon wafers'
- DATABASE WPI, Week , Derwent Publications Ltd., London, GB, Class , AN 91-011695 & JP 02285051

## Description

The present invention relates to an aqueous ammonia composition having low surface tension useful, for example, for cleaning substrate in the field of semiconductor industry. More particularly, the present invention relates to an aqueous ammonia composition having low surface tension which contains a specific fluoroalkylsulfonamide and is suitable as a cleaning agent which is used in semiconductor industry.

With the development of electronic industry, various semiconductor elements are designed and manufactured. In these semiconductor elements are generally used silicon wafers as substrate. In the process for manufacturing semiconductors, an aqueous ammonia is used in combination with other substances for cleaning silicon substrates, especially, in order to remove microparticles therefrom and eliminating residual matters after resist ashing.

In recent years, the density of integrated circuits is becoming increased to induce patterns more minute and complicate. The use of a conventional ammonia water having high surface tension in such case inevitably gives rise to trouble in cleaning such that removal of microparticles existing in gaps between micropatterns becomes difficult.

RCA-cleaning was reported by W. Kern et al.: RCA Review 31, PP 187-205, June (1970) and has been widely utilized in semiconductor industries. In the RCA-cleaning, usually, ammonia water is used as a mixed solution with an aqueous hydrogen peroxide, the proportion of such mixed solution being typically 1 (ammonia):l (hydrogen peroxide):6 (water) in terms of volume ratio.

In cleaning of silicon substrate with such mixed solution, however, it has been realized that the mixed solution causes some problems as follows:
(1) Particle adhesion
(2) Microroughness
(3) Metallic adhesion.

As a result, the treated substrate becomes coarse and permits the formation of fine pits, which causes deterioration of the resultant semiconductor elements.

The document EP-A- 0 416 126 discloses a solution of sulfamic acid having a low surface tension, containing a surfactant of the general formula R'SO₂NR²C₂H₄OA (R' is a fluoroalkyl group, R² is H or a lower alkyl group and A is H or SO₂H.

Accordingly, it has been requested to develop a new type aqueous ammonia composition which overcomes these drawbacks in prior art and which has a low surface tension and besides such characteristic properties that the cleaning performance is remarkably increased without damaging the surface of the substrate.

It is an object of the present invention to provide a new aqueous ammonia composition which overcomes the drawbacks of the conventional ammonia water composition as cleaning agent.

It is another object of the present invention to provide a new type aqueous ammonia composition having low surface tension and an improved effect in removing microparticles of any materials from the micropatterns on the surface of a semiconductor substrate.

It is still another object of the present invention to provide a new type aqueous ammonia composition which is chemically stable and gives no harmful effect on semiconductor substrates but rather a good effect for protecting the surface and further provides good quality and trustability of semiconductor elements.

It is a further object of the present invention to provide a cleaning agent for a semiconductor substrate.

It is still a further object of the present invention to provide the use of a new type aqueous ammonia composition for a surface-cleaning treatment of semiconductor substrate.

Other objects, features and advantages of the present invention will become apparently more fully from the following description.

As a result of extensive research made by the present inventors in order to overcome various drawbacks brought about by use of the conventional aqueous ammonia-hydrogen peroxide solution, it has now been found surprisingly that a composition containing a specific surfactant of fluorine series is chemically stable in a mixed solution of ammonia water together with aqueous hydrogen peroxide and has a lowered surface tension and that the composition has the improved effect of removing very fine impurity particles from the surface of semiconductor substrates without giving harmful effects on the substrates. The present invention has been accomplished on the basis of the above finding.

The present invention provides a new cleaning agent as defined by the subject matter of claim 1.

The present invention, further, provides a cleaning agent for a semiconductor substrate which comprises the aqueous ammonia composition to be mixed with an aqueous hydrogen peroxide solution and water, to obtain the cleaning agent.

The present invention also provides a cleaning agent consisting of two separate parts as defined in claim 6.

The present invention, furthermore, provides a use of the aqueous ammonia composition as a cleaning agent in the cleaning up a semiconductor substrate for removing very fine impurity particle materials therefrom and for protecting the surface of the substrate, as defined in claim 7.

In the composition of the present invention, the fluoroalkylsulfonamide compound of the general formula (I) given in claim 1 used as the main ingredient therein is soluble in water but should not contain any alkali or alkaline earth metal such as sodium, potassium or calcium in the molecule thereof.

The fluoroalkylsulfonamide compound is commercially available as a surfactant of fluorine series or can easily be prepared according to a method known per se.

In connection with the general formula (I), examples of the group R¹ include a linear or branched alkyl group of 1-18 carbon atoms, preferably 1-8 carbon atoms having one or more fluorine atoms in the group. Examples of the group R² include an alkyl group having 1-4 carbon atoms, which may be of a straight or branched chain, preferably a methyl, ethyl or propyl group. When X stands for the grouping CH₂COO, the acetic acid group in the compound should not form a salt with an alkaline substance having a metal such as NaOH or K₂CO₃. When X stands for the grouping (CH₂CH₂O)ₙ, it is derived from ethylene oxide by polycondensation.

Ammonia water for dissolving the fluoroalkylsulfonamide to prepare the composition of the present invention preferably has a concentration as high as possible. Ammonia water having a concentration higher than 15% by weight is preferable for use in the present invention. In the present invention, the use of an ammonia water having a maximum concentration of about 26-29% by weight at room temperature is most preferable.

The aqueous ammonia composition of the present invention having low surface tension is readily prepared by dissolving a given amount of the above fluoroalkylsulfonamide compound in ammonia water. In this case, the proportion of the fluoroalkylsulfonamide compound is defined as 0.001-0.3% by weight, preferably 0.005-0.2% by weight based on ammonia water. If the proportion of the fluoroalkylsulfonamide compound is less than 0.001% by weight, the resultant composition fails to give an advantageous effect. On the other hand, if the proportion exceeds 0.3% by weight, no additional effect is achieved so that the upper limit is set for an economical reason.

The aqueous ammonia composition of the present invention is stable on storage at ambient temperature for an extended period of time and has a surface tension as low as about 1/3 of that of ammonia water. Accordingly, the composition exhibits a smaller contact angle against silicon substrate so that the composition can easily permeate into fine structure of the patterns. Further, the composition of the present invention was found to possess a high rate of removal of microparticles from the surface or fine grooves in the pattern of the semiconductor substrate.

In case of ammonia water, its contact angle against silicon substrate is relatively large so that wettability of the substrate with ammonia water is far inferior to the case of the composition of the present invention. In such situation, addition of a surfactant to ammonia water as a cleaning agent is naturally thinkable for the purpose of improving wettability of the substrate with the ammonia water. It has been found that addition of any other conventional surfactant to ammonia water is far more inactive for improving the cleaning characteristics of ammonia water than the above specific fluoroalkylsulfonamide compound in the present invention as a component of the cleaning agent for semiconductor substrate. In view of its excellent stability and outstanding effect for removing microparticles from the fine structure of patterns on the substrate, the improvement in the cleaning charcteristics of the cleaning agent for semiconductor substrates is quite unexpected.

The aqueous ammonia composition in this invention may be incorporated with a small amount of various auxiliary substances so far as they do not destroy stability of the composition or deteriorate the cleaning performance of the composition. Such auxiliary substances include a water-miscible organic solvent capable of promoting cleaning effect, such as dioxane, a dye for coloring the composition to distinguish it from other aqueous agent such as ammonia water, etc.

The aqueous ammonia composition of the present invention may be prepared just before using for cleaning semiconductor substrate or may previously be prepared and stored.

On actual use of the composition for cleaning a semiconductor substrate, the composition is mixed with an aqueous solution of hydrogen peroxide and water. An aqueous solution of hydrogen peroxide used for this purpose preferably as a high concentration of at least 15% by weight. The use of 25-35% by weight of hydrogen peroxide is preferable in the present invention. In case a high concentration of ammonia water is used, the use of an equiamount of an aqueous hydrogen peroxide solution having a high concentration is preferable.

Further, a proper amount of water is also used for preparing a cleaning agent from the aqueous ammonia composition. The use of water is preferable for maintaining stability of the cleaning agent at ambient temperature. The amount of water is normally larger than a total amount of the aqueous ammonia composition and the aqueous hydrogen peroxide solution and is properly determined according to the cleaning purpose.

The present invention will be illustrated in more detail by way of Examples and Comparative Examples.

### Example 1 Surface tension

Using as a surfactant of fluorine series the following two kinds of the fluoroalkylsulfonamide compound of the general formula (I):
- Compound A:: [in the formula (I), R¹ stands for C₈F₁₇, R² for C₃H₇, and X for (CH₂CH₂O)₁₁]
- Compound B:: [in the formula (I), R¹ stands for C₈F₁₇, R² for C₃H₇, and X for CH₂COO],

5kg of 29% by weight of ammonia water was incorporated with 1.5g of the above Compound A or B, and the two kinds of the mixture was stirred to prepare two aqueous ammonia compositions containing the above Compounds A and B, respectively. Each composition was then mixed with a 30% by weight aqueous solution of hydrogen peroxide and water in a mixing ratio of 1:1:5 to prepare a cleaning agent (solution). The surface tension of each of the cleaning solution was measured at 20°C according to the Wilhelmy method. For the purpose of comparison, the above ammonia water free from the fluoroalkylsulfonamide compound was also subjected to the measurement of surface tension. A result of the measurements is shown in Table 1 below.

**Table 1**

| Surfactant of fluorine series | Surface tension(dyn/cm) |
|---|---|
| None (control) | 63.0 |
| Compound A | 20.4 |
| Compound B | 16.4 |

(One dyn/cm equals 0.102 mg weight/mm).

### Example 2 Contact angle

Using the aqueous ammonia composition containing Compound A which is prepared in the same manner as described in Example 1, the contact angle against bare silicon wafers was measured according to a usual manner using a conventional protractor. Another measurement was also carried out by using only the same ammonia water as comparison test. A result of the measurement is shown in Table 2 below.

**Table 2**

| Compound A(% by weight) | Contact angle (°) |
|---|---|
| 0 (control) | 47.5 |
| 0.01 | 27.5 |
| 0.02 | 13.5 |

### Example 3 Effect of removing microparticles (1) <Dust in the air>

Bare silicon wafers having a diametre of 10 cm (4 inch) were so exposed in the air as to allow dust to attach thereto. On the other hand, 5kg of 29% by weight ammonia water was incorporated with 1.5g of each of the two kinds of the fluoroalkylsulfonamide compounds (the above Compounds A and B) to prepare an aqueous ammonia composition. Each composition was then mixed with 30% by weight aqueous hydrogen peroxide and water in a mixing ratio of 1:1:6 in terms of volumetric ratio to prepare a cleaning solution. Using each cleaning solution, the dust in the above wafers was removed under such condition that the wafers were dipped in the cleaning solution for 10 minutes at 25°C, rinsed with water for 5 minutes, spin-dried for 30 seconds at 3000 r.p.m. and checked for the number of microparticles of dust remaining on the wafers using a surface-examination device (Surfscan 4500). For the purpose of comparison, a similar test was made using the above ammonia water alone under the same condition as above. A result of the test is shown in Table 3 below.

**Table 3**

| Surfactant of fluorine series | Number of Microparticles (≥0.24µm/wafer) | | |
|---|---|---|---|
| | Before rinsing | After rinsing | Rate of removal |
| None (control) | 15729 | 1576 | 89.9% |
| Compound A | 24648 | 343 | 98.6% |
| Compound B | 24615 | 835 | 96.6% |

### Example 4 Effect of removing microparticles (2) <Polystyrene latex (1)>

Bare silicon wafers having a diametre of 10 cm (4 inch) were dipped in a diluted hydrofluoric acid having dispersed therein polystyrene latex (a trade name "STADEX" manufactured by Japan Synthetic Rubber Co., Ltd.; particle size: 0.309µm) whereby the polystyrene microparticles were attached to the surface of the wafers. 5kg of 29% by weight of ammonia water was incorporated with 1.5g of each of the two kinds of fluoroalkylsulfonamide compounds (the above Compounds A and B) to prepare two kinds of the aqueous ammonia compositions. Each of the aqueous ammonia compositions was mixed with a 30% by weight aqueous hydrogen peroxide and water in a mixing ratio of 1:1:6 in terms of a volumetric ratio to prepare two kinds of cleaning solution. Using each of the cleaning solution, removal of the polystyrene microparticles on the surface of the wafer was carried out under such condition that the wafer was dipped in the cleaning solution for 10 minutes at 50°C, rinsed with water for 5 minutes, spin-dried for 30 seconds at 3000 r.p.m. and then checked for the number of polystyrene microparticles remaining on the silicon wafer using a surface-examination device (Surfscan 4500). A similar test was made using the above ammonia water alone under the same condition as above. A result of the tests is shown in Table 4 below.

**Table 4**

| Surfactant of fluorine series | Number of Microparticles (≥0.24µm/wafer) | | |
|---|---|---|---|
| | Before rinsing | After rinsing | Rate of removal |
| None (control) | 2644 | 431 | 83.7% |
| Compound A | 2428 | 75 | 96.9% |
| Compound B | 2075 | 49 | 97.6% |

### Example 5 Effect of removing microparticles (3) <Polystyrene latex (2)>

In the same manner as in Example 4, a bare silicon wafer having a diametre of 10 cm (4 inch) was dipped in a diluted hydrofluoric acid having dispersed thereinto polystyrene latex (STADEX, particle size: 0.309µm) to attach particles of polystyrene onto the surface of the wafer. On the other hand, 5kg of 29% by weight of ammonia water was incorporated with 5g of a fluoroalkylsulfonamide compound (the above Compound A) to prepare an aqueous ammonia composition. Next, this composition was mixed with a 30% by weight aqueous hydrogen peroxide solution and water in a mixing ratio of 1:1:6 by volume to prepare a cleaning solution. Using this cleaning solution, the silicon wafer was washed under such condition that the wafer was dipped for 10 minutes at 50°C and rinsed with water for 5 minutes and checked for the number of polystyrene microparticles remaining on the wafer using the above Surfscan 4500. For the purpose of comparison, a similar test was made using the above ammonia water alone. A result of the tests is shown in Table 5 below.

**Table 5**

| Surfactant of fluorine series | Number of Microparticles (≥0.24µm/wafer) | | |
|---|---|---|---|
| | Before rinsing | After rinsing | Rate of removal |
| None (control) | 10789 | 1652 | 84.7% |
| Compound A | 18432 | 160 | 99.1% |

### Example 6 Effect of removing microparticles (4) <Polystyrene latex (3)>

The test as described in Example 5 was repeated except that 5kg of ammonia water was incorporated with 1.5g of the above Compound A and the obtained ammonia composition was mixed with a 30% by weight aqueous hydrogen peroxide solution and water in a mixing ratio of 0.1:1:6 by volume to prepare a cleaning solution and the test was carried out using the cleaning solution under such condition: 70°C, 10 minutes in the dipping treatment; and 5 minutes in the rinsing treatment. Then, the treated silicon wafer was checked for the number of polystyrene microparticles remaining on the wafer using the above Surfscan 4500. For comparison, another test was carried out using the above ammonia water alone under the same testing condition. A result of the tests is shown in Table 6 below.

**Table 6**

| Surfactant of fluorine series | Number of Microparticles (≥0.24µm/wafer) | | |
|---|---|---|---|
| | Before rinsing | After rinsing | Rate of removal |
| None (control) | 11811 | 1843 | 84.4% |
| Compound A | 11414 | 98 | 99.3% |

### Example 7 Surface-protecting effect

In 5kg of 29% by weight of ammonia water was dissolved 1.5g of a fluoroalkylsulfonamide compound (the above Compound A) to prepare an aqueous ammonia composition. This composition was mixed with a 30% by weight aqueous solution of hydrogen peroxide and water in a mixing ratio of 1:1:6 by volume to prepare a cleaning solution. Using this cleaning solution, the same bare silicon wafer as used in Example 6 was repeatedly washed under such treatment condition that the dipping treatment was carried out for 12 hours at 20°C and the rinsing treatment was carried out repeatedly for 5 minutes. An examination of the surface of the wafer was then made using the same Surfscan 4500 as above to check the defect of the surface in terms of the number of pits. For comparison, the same test was made using the above ammonia water alone under the same testing condition. A result of the test is shown in Table 7 below.

**Table 7**

| Surfactant of fluorine series | Repeated times of washing | |
|---|---|---|
| | 1 (once) | 2 (twice) |
| None (control) | 51 | 217 |
| Compound A | 8 | 16 |

As is evident from the above Examples and Comparative Examples, the aqueous ammonia composition of the present invention and an aqueous ammonia composition using other surfactants exhibit a similar effect on lowering the surface tension of ammonia water, but it is well understood that the aqueous ammonia composition of the present invention exhibit in fact an outstanding stability, for example, on a long-term storage and effect of removing microparticles of foreign materials and also excellent surface-protecting effect on a semiconductor substrate. Such effects are quite unexpected from conventional cleaning agent using ammonia water.

Accordingly, the technical effects achieved by using the specific surfactant for ammonia water are excellent and beneficially applicable to the manufacture of high density integrated circuits.

## Claims

1. A cleaning agent for semiconductor substrates, which comprises ammonia water incorporated with a fluoroalkylsulfonamide compound in a proportion of 0.001-0.3% by weight based on the ammonia water, said fluoroalkylsulfonamide compound having the following general formula:
R¹SO₂NR²-X-H (I)
wherein R¹ stands for a fluoroalkyl group, R² for a hydrogen atom or a lower alkyl group, X for the grouping:
CH₂COO
or
(CH₂CH₂O)ₙ
where the grouping (CH₂CH₂O)ₙ is derived from ethylene oxide by polycondensation and where n is a positive integer up to 20 and an aqueous solution of hydrogen peroxide and water.

2. The cleaning agent according to claim 1, wherein the ammonia water has a high concentration of at least 15% by weight.

3. The cleaning agent according to claim 2, wherein the aqueous solution of hydrogen peroxide has a concentration of at least 15% by weight.

4. A composition to be used in preparing the cleaning agent of claim 1 having low surface tension, which composition comprises ammonia water incorporated with a fluoroalkylsulfonamide compound in a proportion of 0.001-0.3% by weight based on the ammonia water, said fluoroalkylsulfonamide compound having the following general formula:
R¹SO₂NR²-X-H (I)
wherein R¹ stands for a fluoroalkyl group, R² for a hydrogen atom or a lower alkyl group, X for the grouping:
CH₂COO
or
(CH₂CH₂O)ₙ
where the grouping (CH₂CH₂O)ₙ is derived from ethylene oxide by polycondensation and where n is a positive integer up to 20.

5. The composition according to claim 4, wherein the ammonia water has a high concentration of at least 15% by weight.

6. A cleaning agent consisting essentially of two separate parts, which parts require mixing prior to use :
a) an aqueous solution of hydrogen peroxide having a concentration of at least 15% by weight, and
b) the composition of claims 4 or 5.

7. Use of the composition according to any of claims 1 to 3 or the composition obtained by mixing parts a) and b) of claim 6 in cleaning up semiconductor substrates.

## Patentansprüche

1. Reinigungsmittel für Halbleitersubstrate, das Ammoniakwasser vermischt mit einer Fluoralkylsulfonamidverbindung in einem Verhältnis von 0,001-0,3 Gew.-%, bezogen auf das Ammoniakwasser, wobei die Fluoralkylsulfonamidverbindung die nachstehende allgemeine Formel besitzt:
R¹SO₂NR²-X-H (I)
wobei R¹ einen Fluoralkylrest bedeutet, R² ein Wasserstoffatom oder einen niederen Alkylrest bedeutet, X den Rest:
CH₂COO
oder
(CH₂CH₂O)ₙ
bedeutet, wobei der Rest (CH₂CH₂O)ₙ aus Ethylenoxid durch Polykondensation abstammt, und n eine positive ganze Zahl bis 20 bedeutet, und eine wäßrige Wasserstoffperoxidlösung und Wasser umfaßt.

2. Reinigungsmittel nach Anspruch 1, wobei das Ammoniakwasser eine hohe Konzentration von mindestens 15 Gew.-% hat.

3. Reinigungsmittel nach Anspruch 2, wobei die wäßrige Lösung von Wasserstoffperoxid eine Konzentration von mindestens 15 Gew.-% hat.

4. Zusammensetzung, die zur Herstellung des Reinigungsmittels nach Anspruch 1 mit einer niederen Oberflächenspannung verwendet wird, wobei die Zusammensetzung Ammoniakwasser vermischt mit einer Fluoralkylsulfonamidverbindung in einem Verhältnis von 0,001-0,3 Gew.-%, bezogen auf das Ammoniakwasser, umfaßt, wobei die Fluoralkylsulfonamidverbindung die nachstehende Formel besitzt:
R¹SO₂NR²-X-H (I)
wobei R¹ einen Fluoralkylrest bedeutet, R² ein Wasserstoffatom oder einen niederen Alkylrest bedeutet, X den Rest:
CH₂COO
oder
(CH₂CH₂O)ₙ
bedeutet, wobei der Rest (CH₂CH₂O)ₙ aus Ethylenoxid durch Polykondensation abstammt, und n eine positive ganze Zahl bis 20 bedeutet.

5. Zusammensetzung nach Anspruch 4, wobei das Ammoniakwasser eine hohe Konzentration von mindestens 15 Gew.-% hat.

6. Reinigungsmittel, bestehend im wesentlichen aus zwei getrennten Teilen, wobei die Teile vor der Verwendung gemischt werden müssen:
a) einer wäßrigen Lösung von Wasserstoffperoxid mit einer Konzentration von mindestens 15 Gew.-% und
b) der Zusammensetzung der Ansprüche 4 oder 5.

7. Verwendung der Zusammensetzung nach einem der Ansprüche 1 bis 3 oder der durch Mischen der Teile a) und b) des Anspruchs 6 erhaltenen Zusammensetzung zur Reingiung von Halbleitersubstraten.

## Revendications

1. Agent de nettoyage pour des substrats semi-conducteurs qui comprend de l'eau d'ammoniaque incorporée avec un composé de fluoroalkylsulfonamide dans une proportion de 0,001-0,3% en poids rapportée à l'eau d'ammoniaque, ledit composé de floroalkylsulfonamide présentant la formule générale suivante :
R¹SO₂NR²-X-H (I)
dans laquelle R¹ représente un groupe fluoroalkyle, R² représente un atome d'hydrogène ou un groupe alkyle inférieur, X représente le groupe :
CH₂COO
ou
(CH₂CH₂O)ₙ
où n est un nombre entier positif allant jusqu'à 20 et où le groupe (CH₂CH₂O)ₙ est dérivé de l'oxyde d'éthylène par polycondensation et une solution aqueuse de peroxyde d'hydrogène et de l'eau.

2. Agent de nettoyage selon la revendication 1, dans lequel l'eau d'ammoniaque présente une concentration élevée d' au moins 15% en poids.

3. Agent de nettoyage selon la revendication 2, dans lequel la solution aqueuse de peroxyde d'hydrogène présente une concentration d'au moins 15% en poids.

4. Composition à utiliser dans la préparation de l'agent de nettoyage de la revendication 1 présentant une faible tension superficielle, laquelle composition comprend de l'eau d'ammoniaque incorporée avec un composé de fluoroalkylsulfonamide dans une proportion de 0,001-0,3% en poids rapportée à l'eau d'ammoniaque, ledit composé de fluoroalkylsulfonamide présentant la formule générale suivante :
R¹SO₂NR²-X-H (I)
dans laquelle R¹ représente un groupe fluoroalkyle, R² représente un atome d'hydrogène ou un groupe alkyle inférieur, X représente le groupe :
CH₂COO
ou
(CH₂CH₂O)ₙ
où n est un nombre entier positif allant jusqu'à 20 et où le groupe (CH₂CH₂O)ₙ est dérivé de l'oxyde d'éthylène par polycondensation.

5. Composition selon la revendication 4, dans laquelle l'eau d'ammoniaque présente une concentration élevée d'au moins 15% en poids.

6. Agent de nettoyage essentiellement constitué de deux parties séparées lesquelles parties exigent un mélange avant l'utilisation :
a) une solution aqueuse de peroxyde d'hydrogène ayant une concentration d'au moins 15% en poids, et
b) la composition des revendications 4 ou 5.

7. Utilisation de la composition selon l'une quelconque des revendications 1 à 3 ou de la composition obtenue en mélangeant les parties a) et b) de la revendication 6 dans le nettoyage de substrats semi-conducteurs.
